# EUROPEAN PATENT APPLICATION

(11) **EP 4 224 539 A1**
(43) Date of publication of application: **09.08.2023**
(21) Application number: 21875532.0
(22) Date of filing: 27.09.2021
(51) Int. Cl.: H01L 33/56, H01L 33/60

(54) **LIGHT-EMITTING DEVICE AND LIGHT-EMITTING DEVICE MANUFACTURING METHOD**

(30) Priority: 30.09.2020 JP 2020165701; 16.09.2021 JP 2021150877
(71) Applicant: Nichia Corporation, Anan-shi, Tokushima 774-8601 (JP)
(72) Inventor: KUSUSE, Takeshi, Anan-shi, Tokushima 774-8601 (JP); TAMURA, Kazuya, Anan-shi, Tokushima 774-8601 (JP)
(74) Representative: Betten & Resch
(86) International application number: PCT/JP2021/035413
(87) International publication number: WO 2022/071230

(57) **Abstract**

Object

To produce a light-emitting device including a light-reflective covering member with high performance.

Solution

The light-emitting device includes a light-emitting element, and a light-reflective covering member including a light-reflective material having a plate shape, silica, and an alkali metal, and covering the light-emitting element. The light-reflective material has a mean particle size of a range of 0.6 µm to 43 µm, and the light-reflective material has an average aspect ratio of 10 or greater.

## Description

### Technical Field

The present disclosure relates to a light-emitting device and a light-emitting device manufacturing method.

### Background Art

Some light-emitting devices such as LEDs include a light-emitting element and a light-reflective covering member that covers a part of the light-emitting element. For example, PTL 1 discloses a light-reflective covering member in which a reflective material including a white pigment such as titanium oxide, zinc oxide, tantalum oxide, niobium oxide, zirconia oxide, or aluminum oxide is contained in a base material made of a heat-resistant resin, such as silicone resin, or an inorganic binder.

### Citation List

### Patent Literature

PTL 1: JP 2014-216416 A

### SUMMARY OF INVENTION

### Problem to Be Solved

Such a light-reflective covering member formed of an inorganic material still has room for improvement to improve a performance of a light-emitting device. In this description, a performance of a light-emitting device refers to, for example, heat resistance, luminous flux, brightness, sharpness in brightness difference (visibility) between a light-emitting surface of the light-emitting device and a non-light-emitting surface of the light-emitting device surrounding the light-emitting surface, reliability (life), and the like.

An object of the present disclosure is to provide a light-emitting device including a light-reflective covering member that allows the light-emitting device to exhibit high performance, especially heat resistance, and a method of producing the light-emitting device.

### Solution to Problem

A light-emitting device according to the present disclosure includes a light-emitting element, and a light-reflective covering member including a plate-shaped light-reflective material, silica, and an alkali metal, and covering the light-emitting element. The light-reflective material has a mean particle size in a range of 0.6 µm to 43 µm, and the light-reflective material has an average aspect ratio that is 10 or greater.

A manufacturing method for a light-emitting device according to the present disclosure includes forming a mixture by mixing a silica powder, a powder containing a light-reflective material having a plate shape, a mean particle size in a range of 0.6 µm to 43 µm, and an average aspect ratio that is 10 or greater, and an alkali solution, applying the mixture to a light-emitting element, and forming a light-reflective covering member by curing the mixture by heating the mixture.

### Advantageous Effects of Invention

According to the light-emitting device and the manufacturing method for the light-emitting device according to an embodiment of the present disclosure, it is possible to provide a light-emitting device including a light-reflective covering member and with high performance of the light-emitting device, especially heat resistance, and a method of producing the light-emitting device.

### BRIEF DESCRIPTION OF DRAWINGS

FIG. 1 is a schematic cross-sectional view of a light-emitting device according to an embodiment of the present disclosure.
FIG. 2 is a partially enlarged cross-sectional view of a light-reflective covering member provided in the light-emitting device illustrated in FIG. 1.
FIG. 3 is an exemplary schematic perspective view of powder of a light-reflective material forming the light-reflective covering member provided in the light-emitting device illustrated in FIG. 1.
FIG. 4A is a schematic cross-sectional view illustrating a step of a first manufacturing method for the light-emitting device illustrated in FIG. 1.
FIG. 4B is a schematic cross-sectional view illustrating a step of the first manufacturing method for the light-emitting device illustrated in FIG. 1.
FIG. 4C is a schematic cross-sectional view illustrating a step of the first manufacturing method for the light-emitting device illustrated in FIG. 1.
FIG. 5 is a schematic cross-sectional view illustrating another step of the first manufacturing method.
FIG. 6A is a schematic cross-sectional view illustrating a step of a second manufacturing method for the light-emitting device illustrated in FIG. 1.
FIG. 6B is a schematic cross-sectional view illustrating a step of the second manufacturing method for the light-emitting device illustrated in FIG. 1.
FIG. 6C is a schematic cross-sectional view illustrating a step of the second manufacturing method for the light-emitting device illustrated in FIG. 1.
FIG. 6D is a schematic cross-sectional view illustrating a step of the second manufacturing method for the light-emitting device illustrated in FIG. 1.
FIG. 7 is a schematic cross-sectional view of a light-emitting device according to another embodiment of the present disclosure.
FIG. 8A is a schematic cross-sectional view illustrating an exemplary manufacturing step of the light-emitting device illustrated in FIG. 7.
FIG. 8B is a schematic cross-sectional view illustrating an exemplary manufacturing step of the light-emitting device illustrated in FIG. 7.
FIG. 8C is a schematic cross-sectional view illustrating an exemplary manufacturing step of the light-emitting device illustrated in FIG. 7.
FIG. 9 is a partially enlarged cross-sectional view of a light-emitting device according to Example 10 in a manufacturing process.
FIG. 10 is a partially enlarged cross-sectional view of a covering member provided in a light-emitting device according to Example 11.

### DETAILED DESCRIPTION OF EMBODIMENTS

Certain embodiments and examples of the present invention are described below with reference to the drawings. The light-emitting device and the method for manufacturing the light-emitting device described below are intended to embody technical idea of the present invention, and the present invention is not limited to the following unless specifically stated. In each drawing, members having identical functions may be denoted by the same reference characters. For ease of explanation or understanding of the gist, the embodiments and examples may be illustrated separately for convenience, but the partial substitutions or combinations of the configurations illustrated in different embodiments and examples are possible. In the embodiments and examples described below, descriptions of matters common to those already described will be omitted, and only different features are described. In particular, the same actions and effects according to similar configurations shall not be mentioned for each embodiment and example. The size, positional relationship, and the like of the members illustrated in the drawings may be exaggerated in order to clarify explanation.

### First embodiment

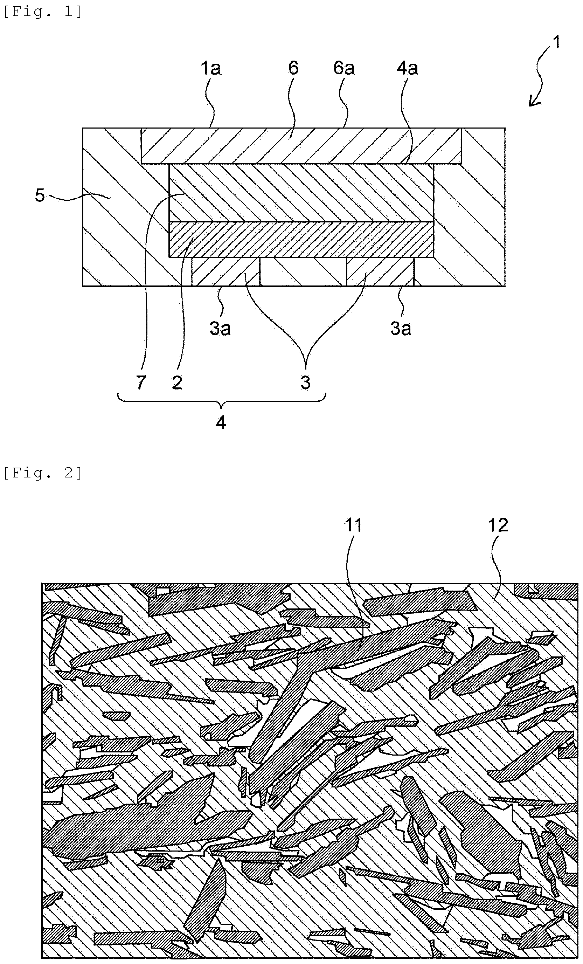

As illustrated in FIG. 1, a light-emitting device 1 according to the present embodiment includes a light-emitting element 4, a light-transmitting member 6, and a light-reflective covering member 5 that covers the light-emitting element 4. The light-emitting element 4 includes a semiconductor layered body 2, and a pair of electrodes 3 provided on the lower surface of the semiconductor layered body 2. The light-transmitting member 6 covers an upper surface 4a of the light-emitting element 4. One of surfaces of the light-transmitting member 6 is exposed from the covering member 5. Among the surfaces of the light-transmitting member 6, a surface of the light-transmitting member 6 that is exposed from the covering member 5 includes a light emission surface 1a of the light-emitting device 1. The covering member 5 covers lateral surfaces and a part of the lower surface of the light-emitting element 4 and lateral surfaces and a part of the lower surface of the light-transmitting member 6. The covering member 5 includes a plate-shaped light-reflective material 11, silica, and alkali metal. A mean particle size of the light-reflective material 11 is in a range of 0.6 µm to 43 µm, and an average aspect ratio of the light-reflective material 11 is 10 or greater.

### Light-Emitting Element

The semiconductor layered body 2 included in the light-emitting element 4 includes an n-type semiconductor layer, a p-type semiconductor layer, a light-emitting portion disposed between the n-type semiconductor layer and the p-type semiconductor layer, for example. The light-emitting element 4 includes a growth substrate 7 (e.g., a sapphire substrate) for growing a semiconductor layer, at a surface of the semiconductor layered body 2 opposite to a surface of the semiconductor layered body 2 where the electrodes 3 are formed. The growth substrate may be removed after the semiconductor layer is formed. The peak wavelength of the light emitted by the semiconductor layered body 2 is in a range of 260 nm to 630 nm, for example. The light-emitting element 4 emits ultraviolet light or blue light, for example. The pair of electrodes 3 provided on the lower surface of the semiconductor layered body 2 are a p-electrode and an n-electrode. In the growth substrate 7, the width of the growth substrate 7 (the length of the longest side of the growth substrate 7 having a polygonal shape in top view) is preferably in a range of 2.5 times to 3.5 times the thickness of the growth substrate 7. Such a relationship between the thickness and the width of the growth substrate 7 allows for improving the light extraction efficiency of the light-emitting element 4.

### Light-Transmitting Member

The light-transmitting member 6 may contain resin or may be an inorganic material. In a case in which the light-transmitting member 6 is an inorganic material, a light-emitting device with high heat resistance can be produced because it has a higher heat resistance than a light-transmitting member containing resin. As the inorganic material, glass may be used, for example. The light-transmitting member 6 can contain wavelength conversion materials such as phosphor. In a case in which the light-transmitting member 6 is a member in which phosphor is contained in an inorganic base material, yttrium aluminum garnet (YAG) can be used as the phosphor, and alumina or silica can be used as the base material, for example. The wavelength conversion material is not necessarily contained in the light-transmitting member 6. In this case, the light from the light-emitting element is emitted to the outside without being subjected to wavelength conversion.

### Covering Member

In the present embodiment, the covering member 5 covers the light-emitting element 4 and the light-transmitting member 6 with a lower surfaces 3a of the electrodes 3 of the light-emitting element 4 and an upper surface 6a of the light-transmitting member 6 exposed from the covering member 5. Here, the term "cover" includes not only a state in which the covering member 5 is disposed in contact with the light-emitting element 4 and/or light-transmitting member 6, but also a state in which the covering member 5 is disposed with another member and/or a space (e.g., an air layer) located between covering member 5 and the light-emitting element 4 and/or light-transmitting member 6. In addition, in this description, the terms "covering", "covered" and the like also include the same states as "cover". In a case in which another member and/or a space (e.g., an air layer) is located between the lateral surface of the light-emitting element 4 and the covering member 5, the inner surface of the covering member 5 facing the lateral surface of the light-emitting element 4 can include an inclined surface inclined such that a distance from the lateral surface of the light-emitting element 4 increases from the lower surface of the light-emitting element toward the upper surface of the light-emitting element in a cross-sectional view. This inclined surface may have a linear shape or a curved shape in a cross-sectional view, for example. The upper surface 6a of the light-transmitting member 6 exposed from the covering member 5 is the light emission surface 1a of the light-emitting device 1. The light-transmitting member 6 is not necessarily provided in the light-emitting device 1 according to the present embodiment. In a case in which the light-transmitting member 6 is not provided, the covering member 5 is disposed such that the upper surface 4a of the light-emitting element 4 and the lower surfaces 3a of the electrode 3 are exposed from the covering member 5, for example. In this case, the upper surface 4a of the light-emitting element 4 serves as the light emission surface.

The covering member 5 is a mixture of a plurality of inorganic materials. The covering member 5 includes the light-reflective material 11, and a support member 12 that supports the light-reflective material 11. The support member 12 contains silica and alkali metal. As described below, the covering member 5 is formed through a step of heating a mixture of powder of the light-reflective material 11, silica powder, and an alkali solution. The covering member 5 may be composed only of an inorganic material or composed mainly of an inorganic material. While the covering member 5 is used as a member for covering the light-emitting element 4 and the light-transmitting member 6 in the example herein, the covering member 5 may be used for other purpose. The covering member 5 according to the present embodiment may be used as a light reflection layer disposed on a surface of the mounting substrate and configured to reflect light travelling from the light-emitting element toward the mounting substrate, for example. In addition, the use of a mixture 50 according to the present embodiment is not limited to the use as the material of the covering member 5 and may be used as the material for a reflection wall that surrounds the light-emitting element in an LED package, for example.

### Light-Reflective Material

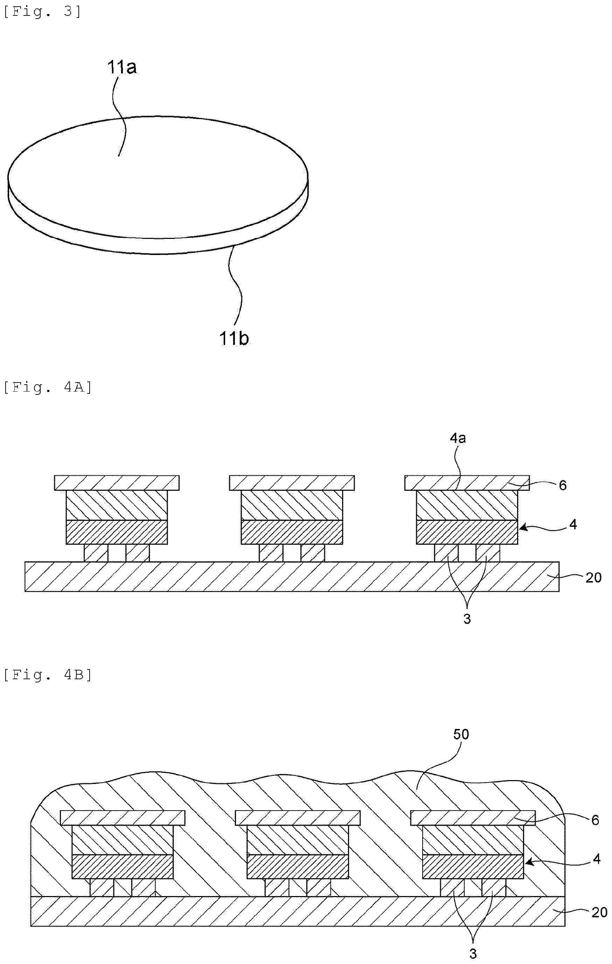

As illustrated in FIG. 3, for example, the powder of the light-reflective material 11 is plate-shaped particles including opposite two main surfaces 11a and 11b. The opposite two main surfaces 11a and 11b of the light-reflective material 11 may also be referred to as upper surface and lower surface of the light-reflective material 11, respectively. In addition, the powder of the light-reflective material 11 may also be referred to as scale-like shaped particles. FIG. 3 is merely a diagram schematically illustrating the powder of the light-reflective material 11 by, for example, regarding it as having a thin columnar shape for ease of illustration of the shape of the powder of the light-reflective material 11. The light-reflective material 11 is boron nitride or alumina, for example. These materials can reflect light of a peak wavelength from the light-emitting element.

The light-reflective material 11 may be a primary particle, or a secondary particle as an agglomeration of two or more primary particles. It may be a mixture of the primary particle and the secondary particle.

The average aspect ratio of the light-reflective material 11 is 10 or greater, desirably in a range of 10 to 70. The average aspect ratio of the light-reflective material 11 is calculated by the following method.

### Calculation Method of Average Aspect Ratio

The average aspect ratio of the light-reflective material 11 is calculated by measuring a thickness and a width of the light-reflective material 11 contained in the covering member 5 in a cross-section of the light-emitting device 1. First, a cross-section that passes through the center of the light emission surface 1a of the light-emitting device 1 and is substantially orthogonal to the light emission surface 1a is exposed. This cross-section is exposed by cutting the light-emitting device 1.

Subsequently, the exposed cross-section is mirror-polished. The mirror polished cross-section is imaged with a scanning electron microscope (SEM), the cross-section of the light-reflective material 11 is extracted, and a measurement region including the cross-sections of approximately 1000 light-reflective materials 11 is selected. The number of pixels of the microscope is set to approximately 20 megapixels, and the magnification is set to 500x to 3000x. In addition, in this description, the cross-section of the light-reflective material 11 is a surface substantially perpendicular to one main surface 11a and/or the other main surface 11b of the light-reflective material 11. Due to their shapes, the plate-shaped light-reflective materials 11 tend to be disposed in an overlapping manner with their main surface 11a or 11b facing each other in the covering member 5. Therefore, the cross-section of the light-reflective material 11 can be appropriately extracted with the SEM by appropriately selecting the cross-section of the light-emitting device 1 to be exposed.

Subsequently, with image analysis software, the width (the length in the long side direction of the cross-section of the light-reflective material) and the thickness (the length in the short side direction of the cross-section of the light-reflective material) of the extracted cross-section of the light-reflective material 11 are measured at one location each to calculate the average value of the widths relative to the thicknesses. Then, the average value of the measurement values of 100 light-reflective materials 11 is set as the average aspect ratio. In a case in which the light-reflective material 11 is boron nitride, the average aspect ratio of the light-reflective material 11 is in a range of 16.5 to 19.2, for example. In a case in which the light-reflective material 11 is alumina, the average aspect ratio of the light-reflective material 11 is in a range of 10 to 70, for example.

In addition, the mean particle size of the light-reflective material 11 is in a range of 0.6 µm to 43 µm. Here, the fusion of the silica powder and the powder of the light-reflective material 11 in the above-described step of heating and the elution of the powder of the light-reflective material 11 to the alkali solution in the step of heating are slight. Therefore, the shape and the dimension of the powder of the light-reflective material 11 and the shape and the dimension of the light-reflective material 11 included in the covering member 5 formed through the step of heating are substantially the same, respectively. Thus, the mean particle size of the light-reflective material 11 is calculated by measuring the particle size of the powder of the light-reflective material 11 through the following method.

### Calculation Method of Mean Particle Size

The particle size of the powder of the light-reflective material 11 is calculated by using a scanning electron microscope "TM3030Plus" available from Hitachi High-Tech Corporation. First, one surface of a double-sided tape made of carbon is attached to the sample stage of the microscope, and thereafter the powder of the light-reflective material 11 is disposed at the other surface of the double-sided tape. The number of pixels of the microscope is set to 1.23 megapixels, and the magnification is set to 1000x to 2000x to acquire the image of the powder (particles) of the 100 light-reflective materials 11. Thereafter, the particle size of each particle is measured with image analysis software. In this specification, the particle size of the powder of the light-reflective material 11 refers to a maximum diameter of the light-reflective material 11 when viewed from above the main surface 11a or 11b of the light-reflective material 11. Subsequently, the median diameter of the measured particle is calculated, and the calculated value is set as the mean particle size of the light-reflective material 11. Alternatively, the particle size of the powder of the light-reflective material 11 may be calculated by extracting the cross-section of the covering member with the SEM and measuring it with the image analysis software.

In a case in which the light-reflective material 11 is boron nitride, the mean particle size of the light-reflective material 11 is in a range of 6 µm to 43 µm, for example. In a case in which the light-reflective material 11 is alumina, the mean particle size of the light-reflective material 11 is in a range of 0.6 µm to 10 µm, for example.

### Silica

The content ratio of the silica and the light-reflective material 11 included in the covering member 5 is in a range of 1:4 to 1:1 by weight, for example. That is, the weight of the light-reflective material 11 included in the covering member 5 is, for example, in a range of one time to four times the weight of the silica included in the covering member 5. When the weight of the light-reflective material 11 is in this range allows for reducing shrinkage of the mixture during curing. If the amount of the light-reflective material is excessively large, the curability may be reduced. On the other hand, if the amount of the silica is excessively large, shrinkage due to curing is increased, and cracks may possibly occur during curing. The mean particle size of the silica is in a range of 0.1 µm to 10 µm, for example. When the weight of the light-reflective material 11 is in this range, the density per volume of the raw materials (such as the light-reflective material and the silica) can be improved, and thus the strength of the covering member can be ensured. The mean particle size of the silica powder is desirably less than the mean particle size of the light-reflective material. Accordingly, the silica powder can fill the voids between the light-reflective materials formed at the time of mixture. The mean particle size of the silica powder is calculated by measuring the particle size distribution of the silica powder by the laser diffraction method. The mean particle size of the silica is a value measured before mixing it with the alkali solution. Because silica powder is melted when mixed with the alkali solution, it is difficult to determine the particle size from the covering member 5. To calculate the content ratio of the silica and the light-reflective material from the covering member, it may be calculated based on the occupancy of the silica and the light-reflective material by observing the cross-section of the covering member extracted by the SEM, for example.

### Alkali Metal

The alkali metal is alkali metal included in the above-described alkali solution. The alkali metal is potassium and/or sodium, for example.

The light-reflective material 11 having the above-described mean particle size and average aspect ratio functions as an aggregate of the covering member 5 when the covering member 5 is heated with the heat generated from the light-emitting element 4. Accordingly, the shrinkage of the covering member 5 due to the heat of the light-emitting element 4 is reduced, and the light-emitting device 1 with high heat resistance can be obtained. Such a light-emitting device 1 has a long usage life. Further, the covering member 5 can reflect light from the light-emitting element due to difference in the refractive index between the light-reflective material and the silica. Furthermore, when the covering member 5 is obtained in which shrinkage due to the heat from the light-emitting element 4 is reduced as described above, the light-emitting device 1 can be used even under a condition where the heat generated from the light-emitting element is increased (e.g., a case in which the amount of power supplied to the light-emitting element is large). Allowing increase in the amount of power supplied to the light-emitting element can increase the quantity of light per light-emitting device. In addition, in comparison with a light-emitting element that emits visible light, a light-emitting element that emits ultraviolet light has a greater amount of energy of light, which may easily cause degradation of resin by light. Thus, the light-emitting element that emits ultraviolet light may be mounted in a ceramic package that is highly durable against light energy. On the other hand, by using the covering member 5 according to the present embodiment, it is possible to provide a light-emitting device in which the light-emitting element that emits ultraviolet light is covered with the covering member 5 without using the ceramic package. In this manner, the light-emitting device including the covering member 5 can be manufactured at a reduced cost and can be reduced in size, in comparison with a light-emitting device including a ceramic package.

The coefficient of terminal expansion of the covering member 5 is preferably in a range of 0.5 ppm/°C to 5 ppm/°C in a temperature range of 40°C to 300°C. In this manner, even when the temperature of the covering member 5 is increased during the use of the light-emitting device, the expansion of the covering member can be reduced, and thus the reliability can be improved. In the present embodiment, the coefficient of terminal expansion of the covering member 5 is approximately 1 ppm.

Furthermore, the covering member 5 desirably contains a scattering material. The scattering material is mainly zirconia or titania, for example. In a case in which the light-emitting element emits ultraviolet light, it is desirable to use zirconia that absorbs less light in the ultraviolet wavelength region. When the covering member 5 contains a scattering material, the light reflectance of the covering member 5 is improved. This allows for sharp brightness difference between the light-emitting surface of the light-emitting device 1 and the covering member 5 (non-light-emitting surface) surrounding the light-emitting surface. That is, the visibility at the light emission surface 1a of the light-emitting device 1 is improved.

For the light scattering material, titania may be used alone, or titania subjected to various surface treatments with silica, alumina, zirconia, zinc, organic or the like may be used. Further, for the light scattering material, zirconia may be used alone, or zirconia subjected to various surface treatments with silica, alumina, zinc, organic or the like may be used. Further, stabilized zirconia or partially stabilized zirconia with calcium, magnesium, yttrium, aluminum, or the like added may also be used.

In a case in which a scattering material is added to the covering member, the scattering material is dispersed in the silica.

The mean particle size of the scattering material is desirably less than the mean particle size of the light-reflective material 11. In this manner, the scattering material is disposed in the gap between the light-reflective materials 11, and thus light emitted from the light-emitting element 4 can be impeded from being emitted outside the light-emitting device 1 through the gap between the light-reflective materials 11. Accordingly, the visibility at the light emission surface 1a of the light-emitting device 1 is improved. The mean particle size of the scattering material is measured by the laser diffraction method.

While the light-emitting device including the light-transmitting member 6 is described in Embodiment 1, the light-emitting device does not necessarily include the light-transmitting member 6. In the light-emitting device including the light-transmitting member 6 in Embodiment 1, the upper surface of the light-transmitting member 6 and the upper surface of the covering member 5 are flush with each other. On the other hand, in a light-emitting device that does not include the light-transmitting member 6, the upper surface of the light-emitting element and the upper surface the covering member are flush with each other.

### Manufacturing Methods

### First Manufacturing Method

An exemplary manufacturing method (first manufacturing method) for the light-emitting device 1 according to the present embodiment will be described with reference to FIGS. 4A to 4C.

### Step of Mounting Light-Emitting Element on Mounting Substrate

First, a plurality of the light-emitting elements 4 are provided, each of which provided with the light-transmitting member 6 disposed on the upper surface 4a. The light-transmitting member contains a phosphor. Subsequently, as illustrated in FIG. 4A, the light-emitting elements 4 are mounted on a mounting substrate 20 at a predetermined interval.

### Step of Forming Mixture by Mixing Powder of Light-Reflective Material, Silica Powder, and Alkali Solution

Subsequently, a mixed powder, obtained by mixing the powder containing the light-reflective material 11 and the silica powder, are mixed with the alkali solution to provide the mixture 50. The mixed powder and the alkali solution are mixed such that they are mixed until uniform viscosity is obtained and then degassed and stirred with a stirring and degassing machine that can perform stirring under reduced pressure, for example. The powder of the light-reflective material 11 has a mean particle size of a range of 0.6 µm to 43 µm, and an average aspect ratio of 10 or greater, desirably in a range of 10 to 70. The powder of the light-reflective material 11 is boron nitride powder or alumina powder, for example. The silica powder has a mean particle size of a range of 0.1 µm to 10 µm, for example. The concentration of alkali in the alkali solution is in a range of 1 mol/L to 5 mol/L, for example. If the concentration of the alkali solution is excessively low, curability may be poor, which may cause the covering member 5 to be reduced in strength or decomposed. On the other hand, if the concentration of the alkali solution is excessively high, excess alkali metal may precipitate and thus reduce the reliability of the light-emitting element. The alkali solution is potassium hydroxide solution or sodium hydroxide solution, for example. The silica powder and the powder of the light-reflective material 11 are mixed with a weight ratio of a range of 1:4 to 1:1, for example. That is, the silica powder and the powder of the light-reflective material 11 are mixed such that the weight of the powder of the light-reflective material 11 is in a range of one time to four times the weight of the silica powder, for example. The alkali solution and the mixed powder are mixed with a weight ratio of a range of 2:10 to 8:10, for example. That is, the alkali solution and the mixed powder are mixed such that the weight of the mixed powder is in a range of 1.25 times to five times the weight of the alkali solution, for example. If the alkali solution is excessively little, multiple fine lumps are formed at the time of mixture, making forming difficult. On the other hand, if the alkali solution is excessively much, cracks may occur during curing, or the strength of the cured covering member may be reduced.

Furthermore, in a case in which a scattering material is contained in the covering member 5 provided in the manufactured light-emitting device 1, the scattering material is mixed with the mixture 50. The mean particle size of the scattering material is smaller than the mean particle size of the powder of the light-reflective material 11, for example. The scattering material mainly includes zirconia or titania, for example.

### Step of Applying Mixture to Light-Emitting Element

In this step, the mixture 50 is applied to at least the lateral surface of the light-emitting element 4. In the present manufacturing method of producing the light-emitting device 1, the mixture 50 is applied onto the mounting substrate 20 so as to cover the light-emitting element 4 and the light-transmitting member 6 as illustrated in FIG. 4B. It is desirable to vibrate the mounting substrate during and/or after the application of the mixture 50 onto the mounting substrate 20. In this manner, the mixture 50 can be easily spread over a wide area. In this step, in a case of the light-emitting device provided with no light-transmitting member 6, the mixture 50 is disposed on the mounting substrate 20 so as to cover only the light-emitting element 4. In addition, the mixture 50 may be applied while vibrating the mixture 50 instead of vibrating the mounting substrate.

In addition, before the application of the mixture 50, a protective film may be formed on the wiring electrodes of the mounting substrate 20 and/or the electrodes 3. This allows for reducing damages such as corrosion of the wiring electrodes of the mounting substrate 20 and/or the electrodes 3 due to the alkali solution contained in the mixture 50. In addition, providing the protective film to the wiring electrodes of the mounting substrate 20 and/or the electrodes 3 allows for reducing damages due to corrosion gas in the atmosphere and the like during the use of the manufactured light-emitting device 1 by. That is, the gas barrier property of the light-emitting device 1 can be improved. The above-described protective film can be formed by atomic layer deposition (ALD). Further, the protective film for the wiring electrodes of the mounting substrate 20 and/or the electrodes 3 may be provided after the application of the mixture 50 or may be provided before and after the application of the mixture 50. The gas barrier property of the light-emitting device 1 can be further improved by providing the protective film for the wiring electrodes of the mounting substrate 20 and/or the electrode 3 before and after the application of the mixture 50.

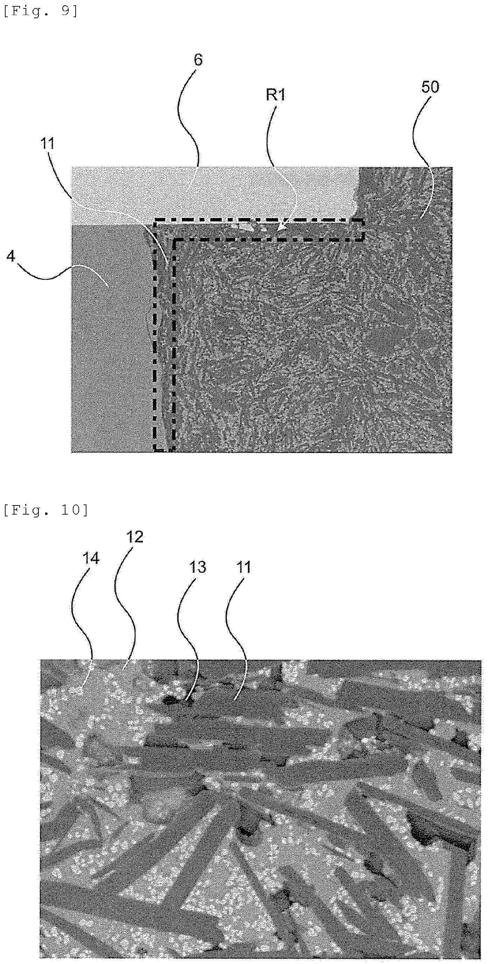

In addition, the upper surface of the mixture 50 may be formed in a flat shape by pressing the mixture with a glass plate after the mixture 50 is disposed on the mounting substrate 20, for example. The light-reflective materials 11 located in a proximate region R1 (see FIG. 9), which is a region proximate to the light-emitting element 4 and the light-transmitting member 6 among the light-reflective materials contained in the covering member 5 in the produced light-emitting device 1, are disposed at an angle of a range of 0° to 45° from the surfaces of the light-emitting element 4 and the light-transmitting member 6 by pressing the upper surface of the mixture 50 into a flat shape. This arrangement state of the light-reflective material 11 will be exemplified in examples to be described below. The proximate region R1 (see FIG. 9) is a region in a range of 10 µm from the surfaces of the light-emitting element 4 and the light-transmitting member 6, for example. Furthermore, in a case in which the surface of the light-emitting element 4 and/or the light-transmitting member 6 is not flat, a surface obtained by averaging the irregularity of that surface is set as the plane of the light-transmitting member. When the light-reflective materials 11 located in the proximate region R1 are disposed in a range of 0° to 45° from the surfaces of the light-emitting element 4 and the light-transmitting member 6 as described above, the light-reflective materials 11 can be disposed such that the main surfaces 11a and 11b face each other and are close to each other. That is, the density of the light-reflective materials 11 in the proximate region R1 can be increased. Thus, in a case in which the light-reflective material 11 is composed of a high heat conduction material such as boron nitride or alumina, dissipation of the heat generated from the light-emitting element 4 and the light-transmitting member 6 can be facilitated, for example.

In addition, silica or alumina can be deposited on the mounting substrate 20 before the application of the mixture 50. This allows for improving the bonding force of the mounting substrate 20 and the mixture 50.

Step of Forming Light-reflective covering member by Heating Mixture/Step of Heating Subsequently, the mixture 50 cured by heating, so that the light-reflective covering member 5 is formed. This step includes a step of semi-curing of the mixture 50 at a first temperature T1 and a step of main curing of the mixture 50 at a second temperature T2 higher than the first temperature T1. The step of semi-curing is performed at the first temperature T1 in a range of 80°C to 100°C for a range of 10 minutes to two hours, for example. The step of main curing is performed at the second temperature T2 in a range of 150°C to 250°C for a range of 10 minutes to three hours, for example. Cracks occur less in the formed covering member 5 by performing the step of semi-curing at a lower temperature than that of the step of main curing before the step of main curing. Furthermore, the light reflectance of the formed covering member 5 is increased by performing the step of semi-curing and the step of main curing while applying pressure. This is thought to be due to that applying the pressure onto the mixture allows the light-reflective materials in the mixture to be cured in the state in which they are more densely disposed. The pressure applied during the step of main curing is 1 MPa, for example.

### Step of Exposing Light-Transmitting Member

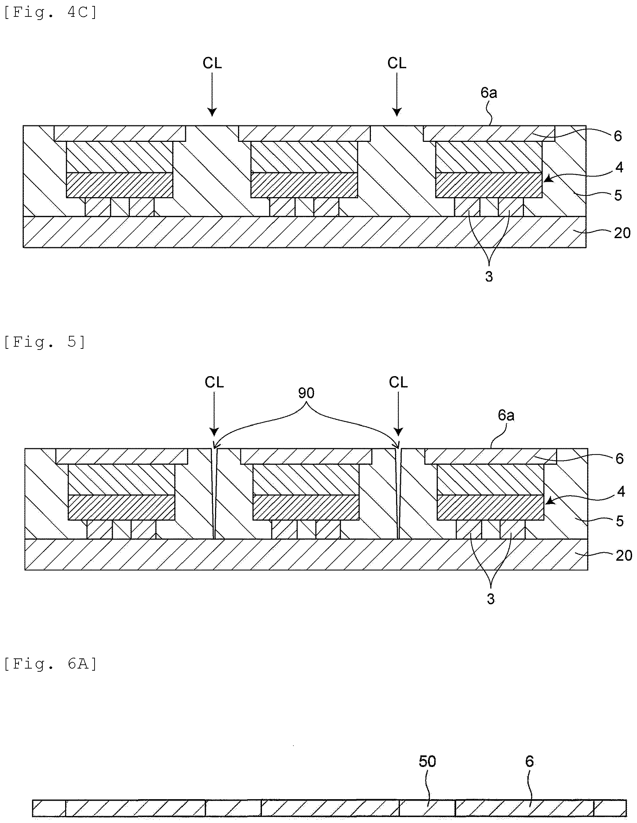

Subsequently, as illustrated in FIG. 4C, the covering member 5 is ground to expose the upper surface 6a of the light-transmitting member 6. The upper surface 6a of the light-transmitting member 6 exposed at this time serves as the light emission surface 1a of the light-emitting device 1.

### Step of Singulation

Subsequently, the light-emitting device 1 is obtained through singulation along a predetermined cutting position CL so as to include a single light-emitting element 4. The singulation is performed by using a blade, for example.

In the first manufacturing method, the mixture 50 is applied to cover the upper surface 6a of the light-transmitting member 6 in the step of applying the mixture, and the upper surface 6a of the light-transmitting member 6 is exposed in the step of exposing the light-transmitting member performed later. However, the mixture 50 may be disposed on the mounting substrate 20 such that the upper surface 6a of the light-transmitting member 6 is exposed in the step of applying the mixture. In this manner, the step of exposing the light-transmitting member may be omitted.

In a case in which the mixture 50 is applied such that the upper surface 6a of the light-transmitting member 6 is exposed in the step of applying the mixture as described above, it is desirable to form a groove 90 in the mixture 50 as illustrated in FIG. 5 after the step of applying the mixture and before the step of heating. The groove 90 is desirably disposed along the cutting position CL in the step of singulation. In addition, it is desirable to divide the covering member by the formation of the groove 90. In this manner, the shrinkage stress generated during curing is directed from the grooving position to the light-emitting element 4, and thus separation between the light-emitting element 4 and the mixture 50 during curing can be impeded. Thus, the bonding strength between the covering member 5 formed by curing the mixture 50 and the light-emitting element 4 can be increased. The grooving is performed by using a blade, for example.

In the above-described step of singulation, the singulation is performed such that a single light-emitting element is included in a single light-emitting device. Otherwise, the singulation may be performed such that two or more light-emitting elements are included in a single light-emitting device. The same applies to the second manufacturing method to be described below.

### Second Manufacturing Method

With reference to FIGS. 6A to 6D, another exemplary manufacturing method (second manufacturing method) for the light-emitting device 1 according to the present embodiment is described.

### Step of Providing Mixture 50 by Mixing Powder of Light-Reflective Material, Silica Powder, and Alkali Solution

A mixed powder, obtained by mixing the powder of the light-reflective material 11 and the silica powder, with alkali solution. This step is the same as the step of forming the mixture 50 by mixing the powder of the light-reflective material, silica powder, and alkali solution in the first manufacturing method.

Step of Providing Light-Transmitting Member with Mixture 50 Disposed at Lateral Surface As illustrated in FIG. 6A, the light-transmitting member 6 with the mixture 50 disposed at the lateral surface is provided. The light-transmitting member 6 with the mixture 50 disposed at the lateral surface is produced as follows, for example. First, one or a plurality of through holes are formed in the mixture 50 in a layered form that is provided, so that the mixture 50 in the layered form having the through hole is formed. In the case in which the plurality of through holes are formed, it is desirable to form the plurality of through holes at a predetermined interval. Subsequently, the light-transmitting member 6 is disposed in through holes. In this manner, the light-transmitting member 6 with the mixture 50 disposed at the lateral surface can be produced. The light-transmitting member may or may not contain a wavelength conversion member (e.g., phosphor). The mixture 50 disposed at the lateral surface of the light-transmitting member 6 may be heated in this step or may be heated after covering the light-emitting element 4 described below with the mixture 50. The through hole may be formed through punching after forming the mixture 50 in the layered form.

### Step of Placing Light-Emitting Element on First Light-Transmitting Member

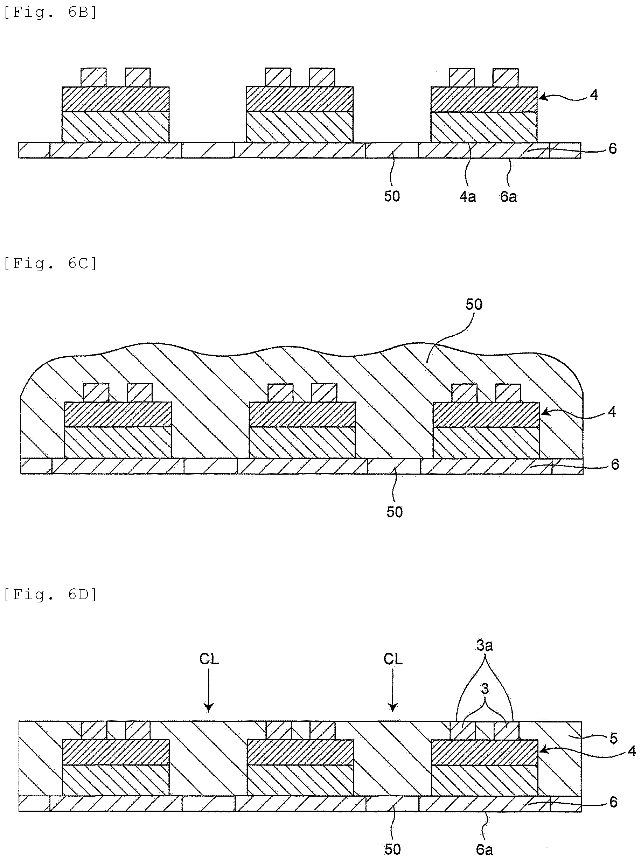

Subsequently, as illustrated in FIG. 6B, the plurality of the light-emitting elements 4 are placed such that the upper surfaces 4a are in contact with the light-transmitting member 6. In the example herein, a surface of the light-emitting element 4 opposite to the surface where the electrodes are formed serves as the upper surface 4a. In addition, a surface of the light-transmitting member 6 opposite to the surface at the light-emitting element side serves as the upper surface 6a.

### Step of Applying Mixture to Light-Emitting Element

Subsequently, as illustrated in FIG. 6C, the mixture 50 is applied on the mixture 50 in the layered form so as to cover the light-emitting element 4. Also in the present manufacturing method, it is desirable to vibrate the mounting substrate during and/or after the application of the mixture 50 as in the first manufacturing method. In addition, also in the present manufacturing method, a protective film may be disposed on the surface of the electrode 3 by atomic layer deposition before and/or after the application of the mixture 50 as in the first manufacturing method.

Step of Forming Light-reflective covering member by Heating Mixture/Step of Heating Subsequently, the mixture 50 is heated and cured to form the covering member 5. This step is the same as the step (step of heating) of forming the light-reflective covering member by heating the mixture in the first manufacturing method.

### Step of Exposing Electrode

Subsequently, as illustrated in FIG. 6D, the covering member 5 is ground to expose the lower surfaces 3a of the electrodes 3 of the light-emitting element 4. In the example herein, the surface of the electrode 3 opposite to the surface proximate to the light-emitting element 4 is the lower surface 3a.

### Step of Singulation

Subsequently, the light-emitting device 1 is obtained through singulation along a predetermined cutting position CL so as to include a single light-emitting element 4. The singulation is performed by using a blade, for example.

While an example in which the mixture 50 is disposed at the lateral surface of the light-transmitting member 6 is described here, a white resin composed of resin containing titanium oxide may be disposed instead of the mixture 50.

### Other Embodiments and Manufacturing Methods Thereof

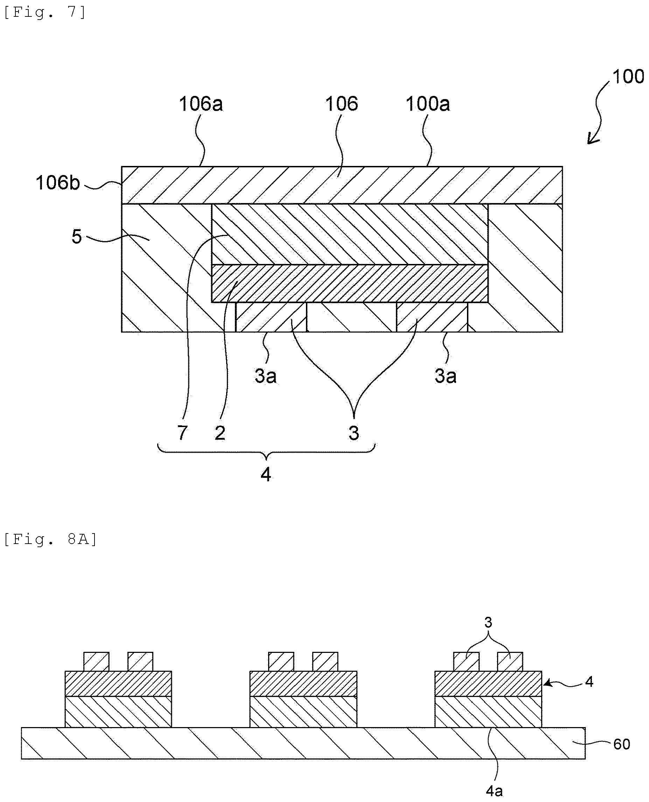

While, in the light-emitting device 1 according to Embodiment 1, the upper surface 6a of the light-transmitting member 6 is exposed from the covering member 5 and the upper surface of the light-emitting device 1 includes the upper surface 6a of the light-transmitting member 6 and the upper surface of the covering member 5, this is not limitative. For example, as illustrated in FIG. 7, an upper surface 106a and a lateral surface 106b of a light-transmitting member 106 may be exposed from the covering member 5 such that the upper surface of the light-emitting device 100 is constituted of only the upper surface 106a of the light-transmitting member 106. The upper surface 106a of the light-transmitting member 106 is a light emission surface 100a of the light-emitting device 100. The light-transmitting member 106 may or may not include a wavelength conversion member (e.g., phosphor).

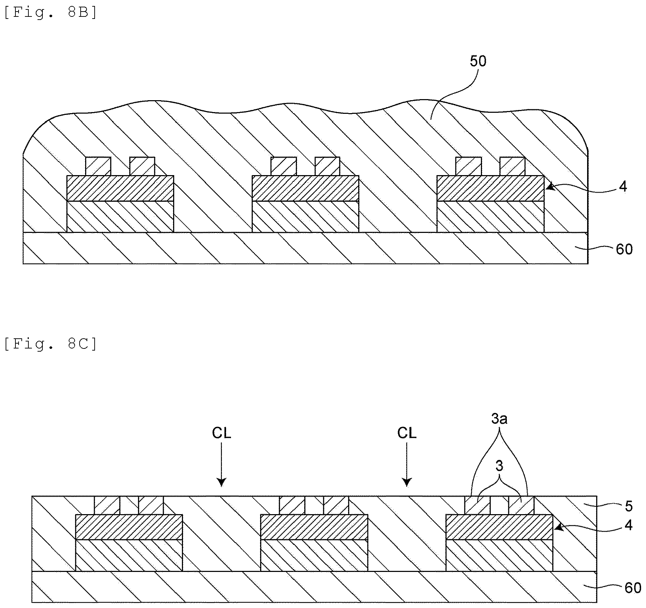

Such a light-emitting device 100 is manufactured by the following manufacturing method. First, as illustrated in FIG. 8A, the plurality of the light-emitting elements 4 are placed on a light-transmitting sheet 60 at a predetermined interval. The light-emitting element 4 is placed on the light-transmitting sheet 60 such that the upper surface of the light-emitting element 4 faces the light-transmitting sheet 60. Subsequently, as illustrated in FIG. 8B, the mixture 50 is disposed on the light-transmitting sheet 60 so as to cover the light-emitting element 4. Thereafter, the mixture 50 is heated to form the light-reflective covering member 5. This step is performed in the same manner as the step (step of heating) of forming the light-reflective covering member by heating the mixture in the first manufacturing method and the second manufacturing method. Subsequently, as illustrated in FIG. 8C, the lower surface 3a of the electrode 3 is exposed, and singulation is performed along the predetermined cutting position CL. In this manner, the light-emitting device 100 can be produced. In the present embodiment, a metal film can be disposed at each of the exposed lower surfaces 3a of the pair of electrodes 3. At this time, the metal film is desirably disposed to cover the lower surface of the covering member 5 around the lower surface 3a in addition to the lower surface 3a of the electrode 3. That is, the metal film is desirably provided in such a manner that the area of the lower surface of the metal film is greater than the area of the exposed lower surface 3a of the electrode 3. In this manner, the electrical connection of the light-emitting device 1 and the wiring substrate is improved. Further, in a case of a configuration in which the electrode 3 contains Cu and the Cu is exposed, mounting failures may occur when the light-emitting device 1 is mounted to the wiring substrate due to oxidation of the Cu, but such a situation does not occur when the electrode 3 is covered with a metal film that is less oxidized than Cu. As such a metal film, a film including Ni, Ru and Au stacked in this order from the electrode 3 may be used. When the outermost surface is composed of Au, which is less oxidized than Cu, the oxidization of the metal film can be reduced. Further, when the metal joined to the electrode 3 in the metal film is composed of Ni, the adhesion between the electrode 3 and the metal film can be increased. The metal film can be formed as follows, for example. A metal film is sputtered on the lower surface 3a of the electrode 3 and the lower surface of the covering member, and the metal film is removed by laser ablation such that the pair of electrodes 3 are electrically divided.

### Examples and Reference Examples

Examples and reference examples are described below. In Reference Example 1, Reference Example 2, and Examples 1 to 9, covering members were produced and the shrinkage maintenance percentage was measured when each of the covering members was heated at 1000°C for one hour. In addition, the amount of alkali solution added was appropriately adjusted so as to obtain a viscosity suitable for forming.

The covering member 5 of Reference Example 1 was produced as follows. First, the powder of the light-reflective material 11 with a mean particle size of 1 µm and an average aspect ratio of 4.6 and silica powder with a mean particle size of 0.4 µm in median diameter were mixed to provide a mixed powder. The powder of the light-reflective material 11 was boron nitride powder. The silica powder and the boron nitride powder were mixed at a weight ratio of 4:5. A mixture was provided by mixing the mixed powder with alkali solution with a concentration of 3 mol/L. The alkali solution was potassium hydroxide solution. The alkali solution and the mixed powder was mixed at a weight ratio of 5.8:9. Subsequently, the mixture 50 was subjected to semi-curing by heating it at a first temperature of 90°C under a pressure of 1 MPa for one hour. Subsequently, the mixture 50 was subjected to main curing by heating it at a second temperature of 200°C under a pressure of 1 MPa for two hours, and thus the covering member 5 was produced.

Each of the covering members 5 of Reference Example 2 and Examples 1 to 9 was produced in the same method as the producing method of Reference Example 1 except for the condition shown in Table 1 such that the material of the light-reflective material, the mean particle size of the light-reflective material, the aspect ratio of the light-reflective material, and the weight ratio of the silica powder and the light-reflective material were changed as shown in Table 1.

Each of the covering members 5 of Reference Example 1, Reference Example 2 and Examples 1 to 9 was divided into two pieces from a plate shape with a diameter of approximately 3 cm and a thickness of approximately 1 mm, and the covering member of one of the divided two pieces was heated at 1000°C for one hour. Thereafter, the percentage (shrinkage maintenance percentage) of the length of one side at the divided cross section of the heated covering member with respect to the length of one side at the divided cross section of the covering member that has not been heated of the covering members divided into two pieces was calculated. Results are shown in Table 1.

**[Table 1]**

| | Light-reflective material | Mean particle size (µm) | Average aspect ratio | Weight ratio | Shrinkage maintenance percentage (%) |
|---|---|---|---|---|---|
| Reference Example 1 | Boron nitride | 1 | 4.6 | 5:4 | 98.33 |
| Reference Example 2 | Boron nitride | 2 | 7.7 | 5:4 | 98.41 |
| Example 1 | Boron nitride | 6 | 17.1 | 1:1 | 99.74 |
| Example2 | Boron nitride | 12 | 16.5 | 5:3 | 99.75 |
| Example3 | Boron nitride | 30 | 19.2 | 5:3 | 99.82 |
| Example4 | Boron nitride | 43 | 18 | 5:3 | 99.61 |
| Examples | Alumina | 0.6 | 10 | 2:1 | 99.70 |
| Example6 | Alumina | 2 | 25 | 2:1 | 99.40 |
| Example7 | Alumina | 5 | 25 | 2:1 | 99.00 |
| Examples | Alumina | 7 | 70 | 2:1 | 99.20 |
| Example9 | Alumina | 10 | 30 | 2:1 | 99.40 |

From the results of Reference Example 1, Reference Example 2 and Examples 1 to 9, the shrinkage maintenance percentage of Examples 1 to 9 was 99.00% or greater, which is greater than the shrinkage maintenance percentages of Reference Example 1 and Reference Example 2. This revealed that the covering member 5 of Examples 1 to 9 including the silica, the alkali metal, and the light-reflective material with a mean particle size of a range of 0.6 µm to 43 µm and an aspect ratio of 10 or greater has high heat tolerance.

In Examples 10 to 13, light-emitting devices each including the covering member 5 were produced, and the light flux, the light-emitting surface brightness, the visibility, and the reliability were evaluated for each of the light-emitting devices. In addition, in Example 10, the cross-section was observed when the covering member 5 applied to the light-emitting element 4 was pressed. In Example 11, the cross-section of the produced light-emitting device was observed with the SEM.

### Example 10

The light-emitting device of Example 10 was produced as follows. A light-emitting element joined with the plate-shaped light-transmitting member 6 including YAG was disposed on an adhesive sheet in the state in which the light-transmitting member 6 faces the adhesive sheet surface. The light-emitting element 4 had a rectangular shape with a size of 1 mm × 1 mm in top view and had a peak wavelength of 450 nm to 455 nm. Each light-emitting element 4 was disposed on the adhesive sheet at a pitch of 1.8 mm in both the X and Y directions (width and depth direction). While a heat-resistant sheet including a polyimide as the base body was used as the adhesive sheet, other materials may be used as long as the adhesive sheet has a heat resistance equal to or greater than the semi-curing temperature. The light-transmitting member 6 had a rectangular shape with a size of 1.1 mm × 1.1 mm in top view and had a thickness of 180 µm. The light-emitting element 4 had a thickness of 200 µm. The electrode 3 of the light-emitting element 4 included Cu with a height of approximately 50 µm. Mixed powder obtained by mixing boron nitride with a mean particle size of 10 µm and an average aspect ratio of approximately 17, and silica with a mean particle size of 0.4 µm at a weight ratio of 1:1 was produced. Thereafter, 3.4 g of 3 mol/L potassium hydroxide solution was added to 10 g of the produced mixed powder, and it was mixed with an agitation rod and then degassed and agitated with an agitation degassing machine that can perform agitation under reduced pressure to obtain white and uniform viscosity-like mixture 50. The obtained mixture 50 was applied to cover the light-emitting element 4 and the light-transmitting member 6. Thereafter, the mixture 50 was pressed with a glass plate to form the mixture 50 into a flat shape with a thickness of approximately 1 mm. FIG. 9 illustrates a cross section that passes through the center of the upper surface 6a of the light-transmitting member 6 in this state and is substantially orthogonal to the upper surface 6a. As illustrated in FIG. 9, the light-reflective materials 11 located near the light-emitting element 4 and the light-transmitting member 6 among the light-reflective materials 11 contained in the mixture 50 tends to be disposed such that the long side direction of the light-reflective material 11 at an angle in a range of 0° to 45° from a side of the light-emitting element 4 and a side of the light-transmitting member 6. It is thought that such an orientational tendency was achieved by increasing the aspect ratio of the plate-shaped light-reflective material 11 and reducing the flow velocity of the mixture 50 flowing near the light-emitting element 4 and the light-transmitting member 6 when applying the mixture 50 to the light-emitting element 4. Subsequently, the mixture 50 was cured by heating, so that the light-reflective covering member 5 was obtained. As the condition of the curing, semi-curing was performed with a pressurizing oven under a pressurized nitrogen atmosphere of 1 MPa for 60 minutes. After removing the sheet, main curing was performed with the pressurizing oven again in a pressurized nitrogen atmosphere of 1 MPa for 40 minutes. The temperature during the main curing was 200°C. Subsequently, the covering member 5 was ground and the electrodes 3 were exposed. Finally, singulation was performed with a blade with a thickness of 100 µm. After the singulation, a light-emitting device for emitting white light with a rectangular shape with a size of 1.7 mm × 1.7 mm in top view and a thickness of approximately 0.4 mm was obtained.

### Example 11

The light-emitting device of Example 11 was produced as follows. A light-emitting device was obtained in the same manner as in Example 10 except that 4 g of 3 mol/L potassium hydroxide solution was added to 13 g of powder material obtained by mixing boron nitride with a mean particle size of 10 µm and an average aspect ratio of approximately 17, silica with a mean particle size of 0.4 µm, and titania with a mean particle size of 0.25 µm, at a weight ratio of 5:5:3. The cross section of this light-emitting device was observed with the SEM. FIG. 10 illustrates a part of the covering member 5 in a cross section that passes through the center of the upper surface 6a of the light-transmitting member 6 and is substantially orthogonal to the upper surface 6a. From FIG. 10, it is clear that voids 13 were present in the covering member 5 and that some voids 13 were in contact with the light-reflective material 11. Locally generating the voids 13 allows for exhibiting an effect of reducing shrinkage of the covering member 5 when it is heat-cured. In addition, in the light-emitting device according to the present example, the reflectance and light-shielding performance was able to improve by adding titania as a scattering material 14, in comparison with a configuration in which titania was not added.

### Example 12

The light-emitting device of Example 12 was produced as follows. A light-emitting device was obtained in the same manner as in Example 10 except that 4.8 g of 3 mol/L potassium hydroxide solution was added to 14 g of a powder material, in which boron nitride with a mean particle size of 10 µm and an average aspect ratio of approximately 17, silica with a mean particle size of 0.4 µm, and zirconia are mixed at a weight ratio of 5:5:4. In the light-emitting device according to the present example, zirconia is added as a scattering material, so that the reflectance and light-shielding performance were able to be improved in comparison with a configuration in which zirconia was not added. In particular zirconia has low light absorption and good reflection performances in the wavelength range of 250 nm to 420 nm, which is the wavelength region of the light-emitting element that emits the ultraviolet light, and thus improvement in characteristics was achieved in the light-emitting device that emits ultraviolet light.

The luminous flux, the light-emitting surface brightness, the visibility, and the reliability of the light-emitting devices of the light-emitting devices of Examples 10 to 12 produced in the above-described manner were compared and evaluated. Light Flux For the light-emitting devices of Examples 10 to 12, the light flux of each light-emitting device was evaluated by using an integrating sphere. The light flux of the light-emitting device of Example 10 was 161 [lm]. The light flux of the light-emitting device of Example 11 was 162 [lm]. The light flux of the light-emitting device of Example 12 was 162 [lm]. The forward current supplied to each of the light-emitting devices of Examples 10 to 12 was 350 [mA].

### Light-Emitting Surface Brightness

When a combination of a light-emitting device and an optical system such as a lens is used, the brightness in a specific light emission area (the light emission surface of the light-transmitting member in a case of the present disclosure) is important. For each of the light-emitting devices of Examples 10 to 12, the brightness of the emission surface (exposed surface) of the light-transmitting member 6 was evaluated by using a two-dimensional colorimeter available from Radiant Vision Systems. The brightness of the light-emitting device of Example 10 was 33.7 [cd/cm²]. The brightness of the light-emitting device of Example 11 was 37.3 [cd/cm²]. The brightness of the light-emitting device of Example 12 was 35.8 [cd/cm²]. The forward current supplied to each of the light-emitting devices of Examples 10 to 12 was 350 [mA].

### Visibility

For car headlights and the like, safety standards apply to light components leaked outside the light emission area, and it is desired to achieve reduction (visibility) of the light components outside the light emission area. When a value obtained by dividing the brightness of light that leaks from the light-transmitting member covering member by the average brightness of light that is emitted from the light-transmitting member 6 was set as an index of the visibility, the obtained values were 7.2% in Example 10, 2.2% in Example 11, and 3.6% in Example 12. The light that leaks from the covering member was light that was measured at a location 125 µm outward from the boundary between the light-transmitting member and the covering member in top view.

### Reliability

A 1000-hour life test was conducted on each of the light-emitting devices of the light-emitting devices of Examples 11 and 12 under a high temperature environment of 85°C and with a current of 1.5A applied. The junction temperature during the operation was approximately 175°C. The "junction temperature" refers to the temperature of the active layer, which is a region where the light of the light-emitting element is emitted. The output maintenance percentage after 1000 hours with respect to the initial value when a current of 700 mA was applied was the output maintenance percentage of 102% for the light-emitting device of Example 11 and the output maintenance percentage of 101% for the light-emitting device of Example 12. In addition, no crack generation or progression was observed in the test on the light-emitting device of Example 11 and the light-emitting device of Example 12.

### Example 13

The light-emitting device of Example 13 was produced as follows. The light-emitting elements 4 each of which has a peak wavelength of 280 nm and a rectangular shape with a size of 1 mm × 1 mm in top view were arranged on an adhesive polyimide sheet at a pitch of 2.2 mm with the sapphire substrate facing the sheet. The light-emitting element 4 had a thickness of 700 µm. The electrode 3 of the light-emitting element 4 included an Au bump with a height of approximately 30 µm. 3 g of 3 mol/L potassium hydroxide solution was added to 10 g of mixed powder obtained by mixing boron nitride with a mean particle size of 10.5 µm and an average aspect ratio of 16.5 and silica with a mean particle size of 0.4 µm at a weight ratio of 1:1, and then they were mixed in a vessel. Thereafter, they were further mixed with a vacuum agitation degassing machine, and thus the mixture 50 was obtained. The obtained mixture 50 was applied to cover the light-emitting element 4 and the light-transmitting member 6. Thereafter, the mixture 50 was pressed with a glass plate and formed into a flat shape with a thickness of approximately 2 mm. Subsequently, semi-curing was performed with an oven in the atmosphere for 60 minutes. The temperature during the semi-curing was 95°C. Thereafter, the polyimide adhesive sheet holding the light-emitting element 4 was removed. After the sheet was removed, main curing was performed with a pressurizing oven in N2 atmosphere of 1 MPa for 40 minutes. The temperature during the main curing was 200°C. Subsequently, the covering member 5 was ground and the electrodes 3 were exposed. Finally, singulation was performed by using a blade with a thickness of 100 µm. After the singulation, a light-emitting device that emits ultraviolet light and has a rectangular shape with a size of 2.1 mm × 2.1 mm in top view and a thickness of approximately 720 µm was obtained.

### Reliability

A reliability test was conducted for the light-emitting device produced in the above-described manner. A 1000-hour life test was conducted under a room temperature environment of 25°C and with a current of 500 mA applied. The junction temperature during the operation was approximately 100°C. The output maintenance percentage after 1000 hours with respect to the initial value when a current of 350 mA was applied was 92%. No deterioration such as discoloration or cracking was observed in the appearance after the test.

While the embodiments, modifications, examples and reference examples of the present disclosure are described above, the disclosure may be changed in compositional detail, and combinations and order changes of the elements and the like in the embodiments, modifications, examples and reference examples may be implemented without departing from the scope and idea of the claimed disclosure. Reference Signs List

1, 100 Light-emitting device
1a, 100a Light emission surface
2 Semiconductor layered body
3 Electrode
3a Lower surface
4 Light-emitting element
4a Upper surface
5 Covering member
6, 106 Light-transmitting member
6a, 106a Upper surface
7 Growth substrate
106b Lateral surface
11 Light-reflective material
11a, 11b Main surface
12 Support member
13 Void
14 Scattering material
20 Mounting substrate
50 Mixture
60 Light-transmitting sheet
90 Groove

## Claims

1. A light-emitting device comprising:
a light-emitting element; and
a light-reflective covering member containing a light-reflective material having a plate shape, silica, and alkali metal, and covering the light-emitting element, wherein
the light-reflective material has a mean particle size in a range of 0.6 µm to 43 µm, and
the light-reflective material has an average aspect ratio of 10 or greater.

2. The light-emitting device according to claim 1, wherein
the light-reflective material is boron nitride; and
a mean particle size of the light-reflective material is in a range of 6 µm to 43 µm.

3. The light-emitting device according to claim 1, wherein
the light-reflective material is alumina; and
a mean particle size of the light-reflective material is in a range of 0.6 µm to 10 µm.

4. The light-emitting device according to any one of claims 1 to 3, wherein a content ratio of the silica and the light-reflective material is in a range of 1:4 to 1:1 by weight.

5. The light-emitting device according to any one of claims 1 to 4, wherein the alkali metal is potassium or sodium.

6. The light-emitting device according to any one of claims 1 to 5, wherein the covering member contains a scattering material.

7. The light-emitting device according to claim 6, wherein a mean particle size of the scattering material is less than the mean particle size of the light-reflective material.

8. The light-emitting device according to claim 6 or 7, wherein the scattering material is mainly made of zirconia or titania.

9. The light-emitting device according to any one of claims 1 to 8, wherein
a light-transmitting member is disposed on the light-emitting element,
one or more surfaces of the light-transmitting member is exposed from the covering member; and
the one or more surfaces of the light-transmitting member exposed from the covering member comprise a light emission surface.

10. The light-emitting device according to claim 9, wherein the light-transmitting member is an inorganic material.

11. The light-emitting device according to any one of claims 1 to 10, wherein the light-emitting element emits ultraviolet light.

12. The light-emitting device according to any one of claims 1 to 11, wherein the covering member has a coefficient of terminal expansion of a range of 0.5 ppm/°C to 5 ppm/°C in a temperature range of 40°C to 300°C.

13. A manufacturing method for a light-emitting device, comprising:
forming a mixture by mixing silica powder, powder of a light-reflective material having a plate shape, a mean particle size of a range of 0.6 µm to 43 µm, and an average aspect ratio of 10 or greater, and alkali solution;
applying the mixture to a light-emitting element; and
forming a light-reflective covering member by curing the mixture by heating the mixture.

14. The manufacturing method for the light-emitting device according to claim 13, wherein
the step of forming the light-reflective covering member comprises:
temporarily curing of the mixture at a first temperature; and
main curing of the mixture at a second temperature greater than the first temperature.

15. The manufacturing method for the light-emitting device according to claim 13 or 14, wherein in the step of forming the mixture, the silica powder and the powder of the light-reflective material are mixed at a weight ratio of a range of 1:4 to 1:1.

16. The manufacturing method for the light-emitting device according to any one of claims 13 to 15, wherein in the step of forming the mixture, a weight ratio of the alkali solution, and the silica powder and the powder of light-reflective material is in a range of 2:10 to 8:10.

17. The manufacturing method for the light-emitting device according to any one of claims 13 to 16, wherein in the step of forming the mixture, the alkali solution having a concentration of a range of 1 mol/L to 5 mol/L is used.

18. The manufacturing method for the light-emitting device according to any one of claims 13 to 17, wherein in the step of forming the mixture, the light-reflective material that is boron nitride or alumina is used.

19. The manufacturing method for the light-emitting device according to any one of claims 13 to 18, wherein in the step of forming the mixture, the alkali solution that is a potassium hydroxide solution or a sodium hydroxide solution is used.

20. The manufacturing method for the light-emitting device according to any one of claims 13 to 19, further comprising mixing a scattering material into the mixture.

21. The manufacturing method for the light-emitting device according to claim 20, wherein in the step of mixing the scattering material in the mixture, the scattering material has a mean particle size less than the mean particle size of the powder of the light-reflective material.

22. The manufacturing method for the light-emitting device according to claim 20 or 21, wherein in the step of mixing the scattering material in the mixture, the scattering material is mainly made of zirconia or titania.
